# EUROPÄISCHE PATENTSCHRIFT

(11) **EP 1 440 606 B1**
(45) Veröffentlichungstag und Bekanntmachung des Hinweises auf die Patenterteilung: **07.11.2007**
(21) Anmeldenummer: 02776676.5
(22) Anmeldetag: 17.09.2002
(51) Int. Cl.: H05K 3/00, H05K 3/46

(54) **SCHICHTENMODELL FÜR DEN ENTWURF EINER MEHRSCHICHTIGEN LEITERPLATTE**
LAMINATED MODEL FOR A MULTILAYER PRINTED CIRCUIT WAFER BLANK
MODELE STRATIFIE POUR EBAUCHE D'UNE PLAQUETTE DE CIRCUIT IMPRIME MULTICOUCHE

(30) Priorität: 02.11.2001 DE 20117912 U; 02.11.2001 DE 10154087
(43) Veröffentlichungstag der Anmeldung: 28.07.2004
(73) Patentinhaber: ILFA Industrieelektronik und Leiterplattenfertigung aller Art GmbH, 30559 Hannover (DE)
(72) Erfinder: WIEMERS, Arnold, 38100 Braunschweig (DE)
(74) Vertreter: Thömen, Uwe
(86) Internationale Anmeldenummer: PCT/DE2002/003460
(87) Internationale Veröffentlichungsnummer: WO 2003/041468

(56) Entgegenhaltungen:
- R. R. MCMAHON ET AL.: "Designing for Manufacturability Overview" PRINTED CIRCUIT DESIGN, Bd. 3, Nr. 4, April 1986 (1986-04), Seiten 3-6, XP008013033 USA

## Beschreibung

Die Erfindung betrifft ein Schichtenmodell für den Entwurf einer mehrschichtigen Leiterplatte nach dem Oberbegriff des Anspruchs 1.

Mehrschichtige Leiterplatten werden zur Realisierung elektronischer Schaltungen mit hochintegrierten Schaltkreisen verwendet. Beim Entwurf mehrschichtiger Leiterplatten müssen eine Vielzahl technischer Anforderungen erfüllt werden. Bisher war es üblich, dass Schaltungsentwickler einem Leiterplattenhersteller Konzepte für die Umsetzung der elektronischen Schaltungen vorlegten und der Leiterplättenhersteller diese Konzepte auf technische Machbarkeit überprüfte. Besonders bei komplexen Aufbauten war ein erheblicher Informationsaustausch nötig, um schließlich ein technisch durchführbares Konzept zu erstellen.

Die bisherige Vorgehensweise könnte vereinfacht werden, wenn dem Schaltungsentwickler zusätzliche Informations- und Testmöglichkeiten zur Verfügung stehen, um vorab das Konzept auf technische Machbarkeit hinsichtlich der Leiterplattenfertigung überprüfen zu können. Dazu sind allerdings disziplinübergreifende Informationen für den Schaltungsentwickler nötig, die einfach anwendbar und umsetzbar sind.

Der Erfindung liegt die Aufgabe zugrunde, ein Schichtenmodell zu schaffen, das auf der Basis der verfügbaren Materialien und mechanischen und technischen Parameter eine Vorabprüfung der Umsetzbarkeit einer elektronischen Schaltung auf eine mehrschichtige Leiterplatte bereits in einem frühen Stadium des Entwurfs einer solchen Leiterplatte ermöglicht.

Diese Aufgabe wird bei einem Schichtenmodell gemäß dem Anspruch 1 gelöst.

Weiterbildungen und vorteilhafte Ausgestaltungen ergeben sich aus den Unteransprüchen.

Mit dem erfindungsgemäßen Schichtenmodell kann in Form eines Baukastens die Konstruktion einer mehrschichtigen'Leiterplatte aus einzelnen Komponenten durchgeführt werden, die sich durch Austausch, Verschieben, Entfernen oder Ergänzen zu einem gültigen und machbaren Schichtenmodell für eine Leiterplatte zusammensetzen lassen. Der Schaltungsentwickler kann so das ihm vorschwebende Konzept erstellen, verändern und auf die technische Machbarkeit überprüfen. Dadurch gelingt es, ein Ergebnis zu erzielen, das entweder bereits als fertiges Konzept umsetzbar ist oder nur noch geringer Modifikationen seitens des Leiterplattenherstellers bedarf.

Gemäß einer Weiterbildung ist vorgesehen, dass die Schichtenmodule wenigstens Basismaterial-Module der Leiterplatte, Isolierschichten-Module und Leiterbahn-Module umfassen.

Mit Hilfe dieser Module ist es bereits möglich, den Schichtaufbau einer mehrschichtigen Leiterplatte zu simulieren und als Konzept vorzugeben. Dabei können in einfacher Weise unterschiedliche Module einzeln kombiniert werden, um empirisch unter Berücksichtigung der Machbarkeit ein Konzept für die Herstellung einer Leiterplatte zu erstellen.

Ergänzend können die Schichtenmodule zusätzlich Kombinations-Module aus miteinander kombinierten Basismaterial-Modulen und/oder Isolierschichten-Modulen und/oder Leiterbahn-Modulen und/oder Impedanz-Modulen und/oder Entkopplungs-Modulen und/oder Kapazitäts-Modulen und/oder Versteifungs-Modulen und/oder Kühlungs-Modulen umfassen.

Mit Hilfe der Kombinations-Module lassen sich bereits vorberechnete Kombinationen realisieren, die auf bestimmte physikalische Anforderungen abgestimmt sind. Dem Schaltungsentwickler ist es dadurch möglich, Kenntnisse aus einer anderen Disziplin, nämlich der Leiterplattenherstellung ohne eigene tiefer gehende Kenntnisse und Berechnungen übernehmen zu können und hiermit ein funktionsfähiges Konzept zu erstellen. Für den Schaltungsentwickler wird damit sinngemäß das Know-How des Leiterplattenherstellers verfügbar gemacht, ohne dass er sich hierbei um Einzelheiten und die Zusammenhänge kümmern muss.

Ferner sind Kontaktierungs-Module und/oder Bohrungs-Module zum Auflegen oder Anlegen an die Schichten-Module vorgesehen. Hierdurch ist es möglich, Kontaktierungswünsche zwischen unterschiedlichen Leiterbahn-Schichten auszuprobieren und auszulegen.

Vorzugsweise weisen der Montagerahmen und wenigstens ein Teil der Schichtenmodule Codierungsnasen und/oder Codierungsausnehmungen auf, die beim bündigen Aneinandersetzen ineinander greifen.

Durch diese Maßnahmen wird erreicht, dass Fehler bei der Zusammenstellung der einzelnen Module sofort erkennbar werden, wenn die Codierungsnasen und/oder Codierungsaizsnehmungen nicht ineinander passen. Hingegen bieten Kombinationen von Schichtenmodulen mit passenden Codierungsnasen und/oder Codierungsausnehmungen die Gewähr, dass derartige Kombinationen auch technisch realisierbar sind.

Bei einer Weiterbildung sind die Schichten-Module sowie die Kontaktierungs-Module und Bohrungs-Module bezogen auf die Schichtdicke der mehrschichtigen Leiterplatte maßstabsgetreu und in einem vergrößerten Maßstab ausgeführt.

Die entsprechenden Module lassen sich so ohne optische Hilfsmittel kombinieren, da sie im vergrößerten Maßstab exakt den späteren Dickenverhältnissen der mehrschichtigen Leiterplatte entsprechen.

Weiterhin ist vorgesehen, dass die Schichten-Module sowie die Kontaktierungs-Module und Bohrungs-Module mehrfach und in den anwendungsüblichen Dicken- und Längenabstufungen vorhanden sind.

Dadurch lassen sich alle anwendungsüblichen Kombinationen hinsichtlich der Materialien und Schichtdicken simulieren und so ein für die spezifische Anwendung machbarer Aufbau erzeugen.

Ferner können die Schichten-Module sowie die Kontaktierungs-Module und Bohrungs-Module Symbole und Beschriftungen tragen.

Diese erleichtern dem Schaltungsentwickler den Aufbau eines Modells allein aufgrund der Informationsträger auf den Modulen selbst und erspart somit die sonst nötige zusätzlich Heranziehung von externen Informationen oder Handbüchern.

Darüber hinaus kann auch der Montagerahmen Beschriftungen tragen.

Diese ermöglichen z. B. eine einfache Überprüfung der gesamten Schichtdicke, ohne dass die Schichtdicken der einzelnen Module addiert werden müssten.

Gemäß einer Weiterbildung ist vorgesehen, dass als Material ein nicht-transparenter Werkstoff dient und die Beschriftungen doppelseitig angeordnet sind.

Bei dieser Ausgestaltung ist es möglich, einerseits das Schichtenmodell von oben zu betrachten, andererseits aber auch auf einer Unterlage zusammengebaut mit der dann gleichartigen Unterseite auf die Glasplatte eines Scanners oder Kopiergerätes zu schieben oder zusammen mit der in diesem Fall transparenten Unterlage zu legen und den Schichtenaufbau mit Übernahme der entsprechenden Symbole und Beschriftungen zu kopieren. Es besteht hier nicht die Gefahr, dass bei dem sonst nötigen Wendevorgang einzelne Module aus dem Montagerahmen herausfallen und falsch zusammengesetzt werden könnten.

Gemäß einer Alternative ist vorgesehen, dass als Material ein transparenter Werkstoff dient und die Beschriftungen einseitig angeordnet sind.

Hierdurch ist es möglich, das Schichtenmodell im Rahmen einer Schulung auch auf einen overhead-Projektor zu legen und über Durchlicht-Projektion darzustellen.

Ergänzend können zusätzlich Informationskarten aus dem gleichen Werkstoff wie der Montagerahmen und die Module mit Hinweisen für den Anwender vorgesehen sein.

Die entsprechenden Hinweise für den Anwender lassen sich auf diese Weise auf dem gleichen Medium darstellen, und somit lassen sich die gleichen Vorteile nutzen die auch für die Schichten-Module und den Montagerahmen gelten.

Nachfolgend wird die Erfindung anhand eines Ausführungsbeispiels erläutert, das in der Zeichnung dargestellt ist.

In der Zeichnung zeigen:
- Fig. 1: einen Montagerahmen mit eingelegten Schichten-Modulen und aufgelegten Kontaktierungs- und Bohrungs-Modulen,
- Fig. 2: einen Montagerahmen mit Informations-Modulen,
- Fig. 3, 4: eine Darstellung unterschiedlicher Schichten-Module als Basismaterial-Module,
- Fig. 5: eine Darstellung unterschiedlicher Schichten-Module als Isolierschichten-Module,
- Fig. 6: eine Darstellung unterschiedlicher Schichten-Module als Leiterbahn-Module,
- Fig. 7: eine Darstellung unterschiedlicher Bohrungs-Module und Kontaktierungs-Module,
- Fig. 8 - 13: eine Darstellung unterschiedlicher Kombinations-Module.

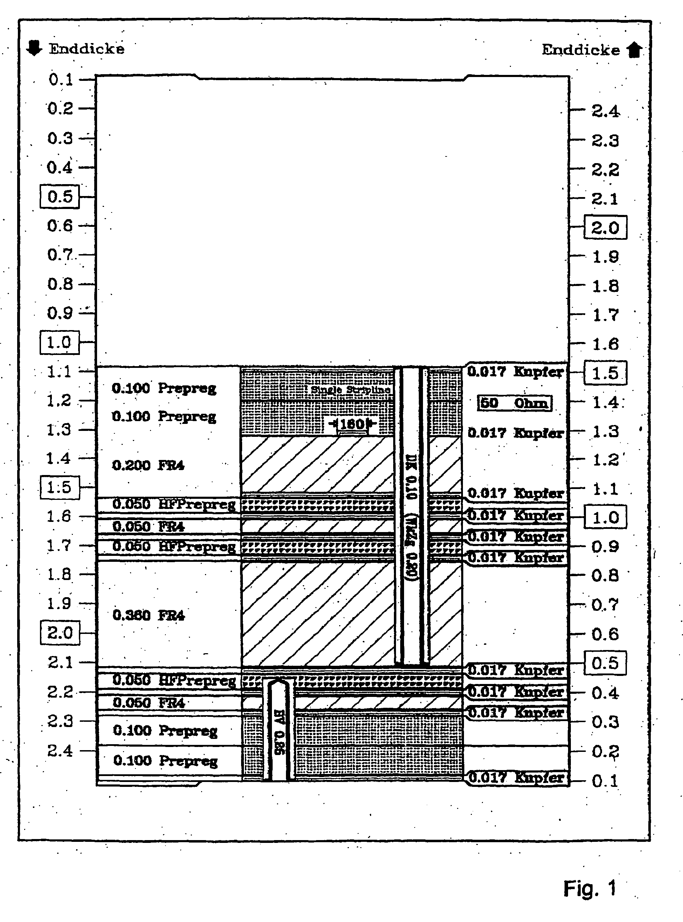

Fig. 1 zeigt einen Montagerahmen mit eingelegten Schichten-Modulen und aufgelegten Kontaktierungs- und Bohrungs-Modulen. Der Montagerahmen hat ca. das Format A4. Der mittlere Bereich des Rahmens enthält ein Fenster, in das die einzelnen Module für den Aufbau der mehrschichtigen Leiterplatte eingelegt werden können.

Eine Skala links und rechts des Fensters zeigt die voraussichtliche Enddicke der mehrschichtigen Leiterplatte an, die diese nach dem Verpressen und der Oberflächenbearbeitung haben wird. Die Kontur des Fensters im Montagerahmens weist an der oberen und unteren Seite links und rechts eine Ausnehmung auf. Diese Ausnehmung hat die Funktion einer Codierung und ermöglicht ein bündiges Anlegen an den Rahmen nur von solchen Schichten-Modulen, die einen mehrschichtigen Aufbau der Leiterplatte abschließen sollten. Die im Rahmen eingelegten Schichtenmodule können hoch und runter verschoben werden. Dadurch sind Ergänzungen oder der Austausch einfach und unkompliziert möglich.

Zu den einsetzbaren Modulen gehören alle Komponenten, die in der Leiterplattentechnik für den Aufbau von mehrschichtigen Leiterplatten erforderlich sind. Bei den Schichtenmodulen handelt es sich in einer Basisausführung um Basismaterial-Module, Isolierschicht-Module und Leiterbahn-Module. Darüber hinaus sind auch Kombinations-Module vorhanden, die aus Basismaterial, Isolierschichten und Leiterbahnen als Laminat gebildet sind. Auch Kombinationen aus Basismaterial und Leiterbahnen oder Isolierschichten und Leiterbahnen sind möglich.

Für den Aufbau einer mehrschichtigen Leiterplatte gilt allgemein die Regel, dass die oberste und unterste Schicht jeweils mit einer Leiterbahn abgeschlossen sein soll. Daher weisen die Leiterbahnebenen stets eine Codiernase auf, die in eine Codierausnehmung am oberen oder unteren Ende des Fensters im Montagerahmen hineinpasst.

Kombinations-Module aus der Kombination einer Isolierschicht mit einer Leiterbahnschicht können beidseitig mit Leiterbahnen oder einseitig belegt sein. Bei beidseitiger Belegung weisen die Kombinations-Module oben und unten eine Codiernase auf, bei einseitig belegten nur an der Leiterbahnebene. Derartige Standartkombinationen müssen immer als Paar zusammengefasst werden.

Auf die in den Montagerahmen eingesetzten Schichten-Module sind Kontaktierungs-Module und Bohrungs-Module aufgelegt. Kontaktierungs-Module veranschaulichen die Möglichkeit einer Durchkontaktierung und Bohrungssymbole die Möglichkeit einer Blindbohrung. Für die Länge der Kontaktierungs-Modüle und Bohrungs-Module wurden fertigungstechnische Einschränkungen für das galvanische Kontaktieren berücksichtigt, die sich aus dem Tiefen-Breiten-Verhältnis der Bohrung ergeben. Lässt sich ein Kontaktierungs-Modul oder Bohrungs-Modul so anlegen, dass die galvanisch miteinander zu verbindenden Leiterbahnflächen überdeckt werden, dann ist ein galvanisches Kontaktieren möglich, anderenfalls ist es nicht möglich.

Die Schichtenmodule sowie die Kontaktierungs-Module und Bohrungs-Module sind im Maßstab 100 : 1 ausgeführt, und in diesem Maßstab ist auch die Beschriftung am Rande des Montagerahmens ausgeführt. Die Schichten-Module sind in drei Felder unterteilt, die beschriftet oder mit Symbolen versehen sind. In der Mitte ist jeweils das Symbol für die Art des Materials, links die Benennung des Materials mit einer Größenangabe und rechts die Art der Leiterbahn, eventuell ergänzt durch elektrische Angaben.

Bei den Kontaktierungs-Modulen und Bohrungs-Modulen ist das Symbol sowie eine Angabe zur Art des Moduls und zum Längen-Durchmesser-Verhältnis eingesetzt.

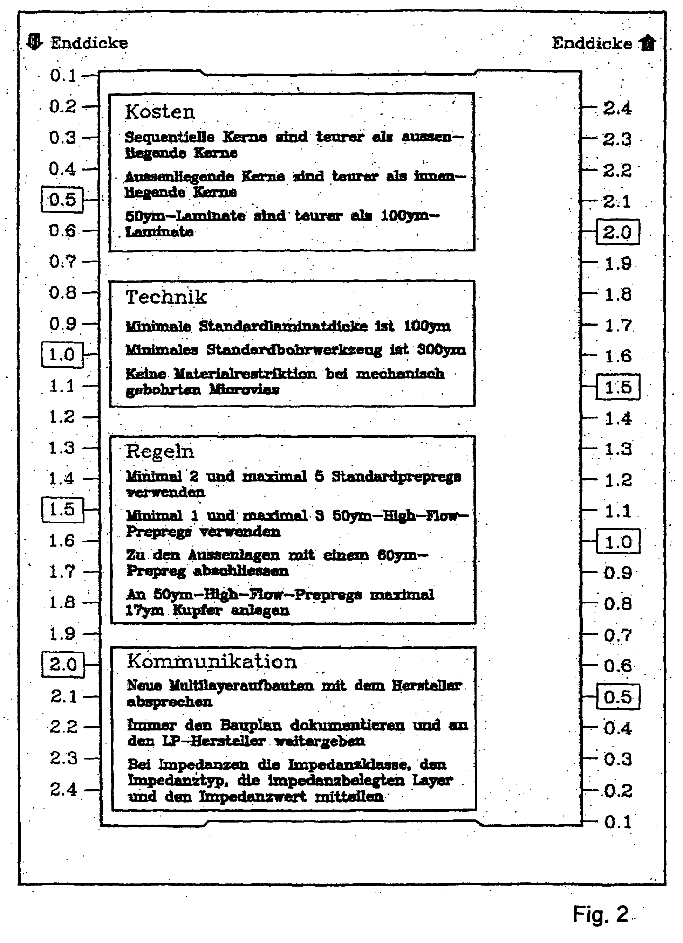

Fig. 2 zeigt eine Darstellung des Montagerahmens ohne eingesetzte Schichten-Module. Zusätzlich sind in das Fenster des Montagerahmens Informationskarten eingelegt.

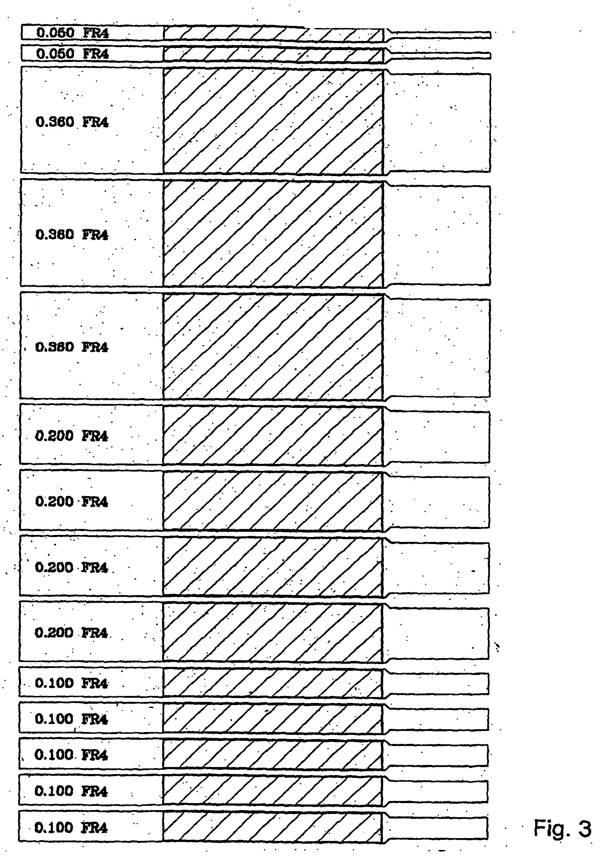

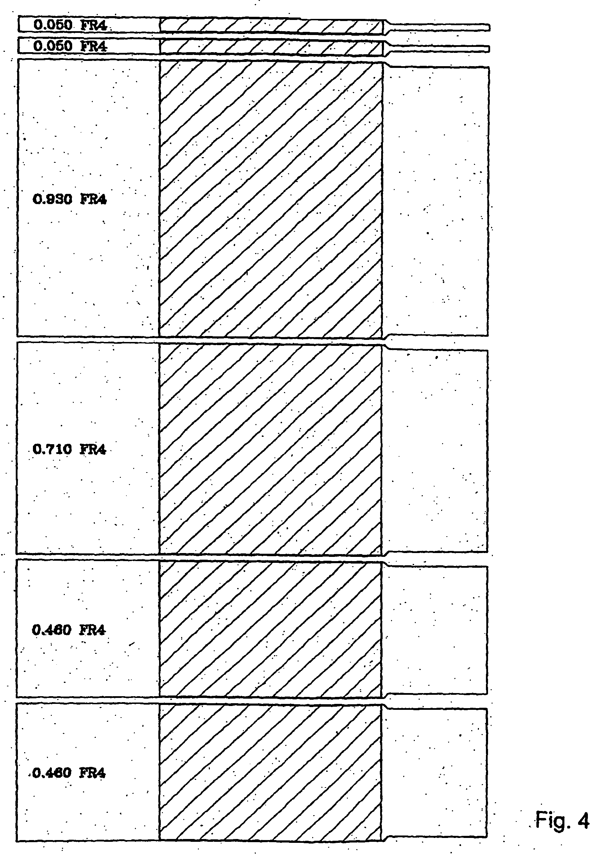

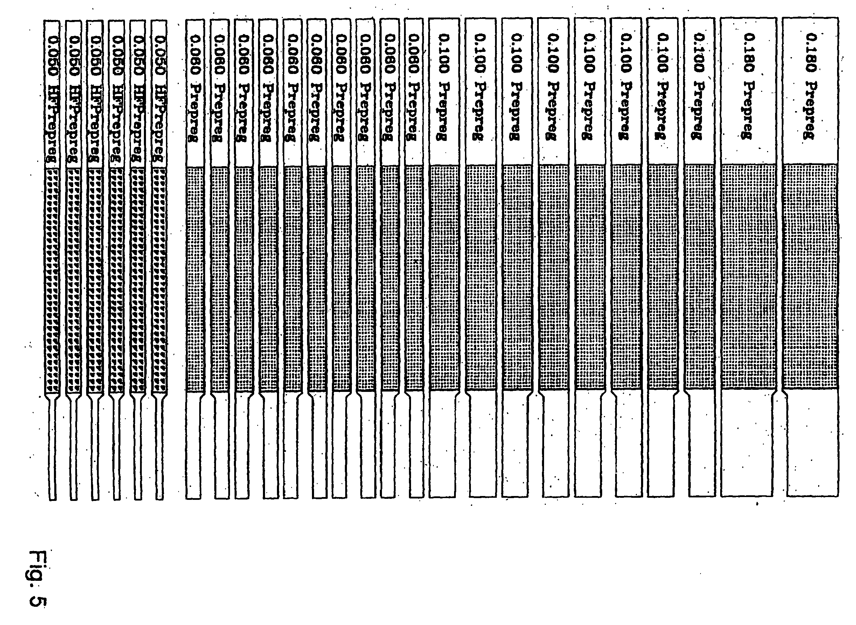

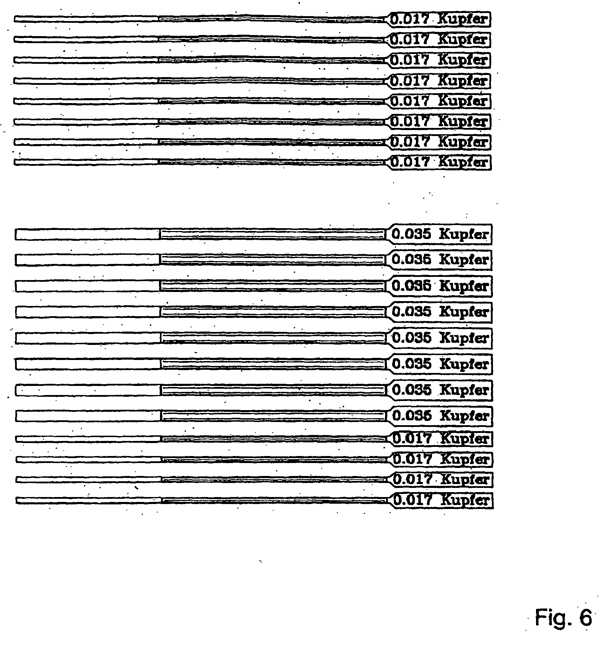

Die Figuren 3 bis 6 zeigen Darstellungen unterschiedlicher Schichten-Module, und zwar in Fig. 3 und 4 Basismaterial-Module, in Fig. 5 Isolierschichten-Module und in Fig. 6 Leiterbahn-Modüle in anwendungsüblichen Dickenabstufungen.

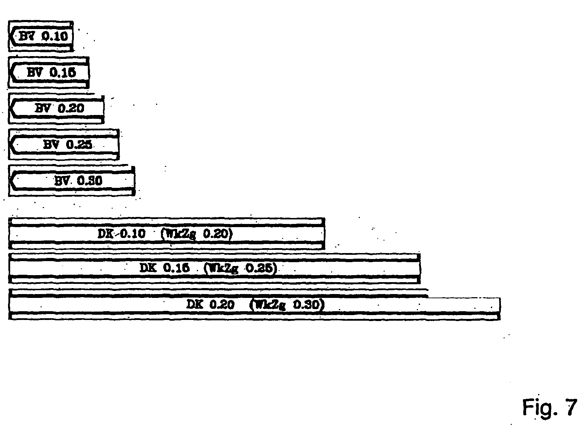

Fig. 7 zeigen oben Darstellungen unterschiedlicher Bohrungs-Module und und unten Darstellungen unterschiedlicher Kontaktierungs-Module. Die einzelnen Module weisen anwendungsübliche Dicken- und Längenabstufungen auf.

In einem Baukastensystem sind die in den Figuren 3 bis 6 dargestellten Module auch bei gleicher Dicke mehrfach vorhanden und die in Fig. 7 dargestellten Module auch bei gleicher Dicke oder Länge mehrfach vorhanden, um entsprechende Kombinationsmöglichkeiten gleichartiger Module zu schaffen.

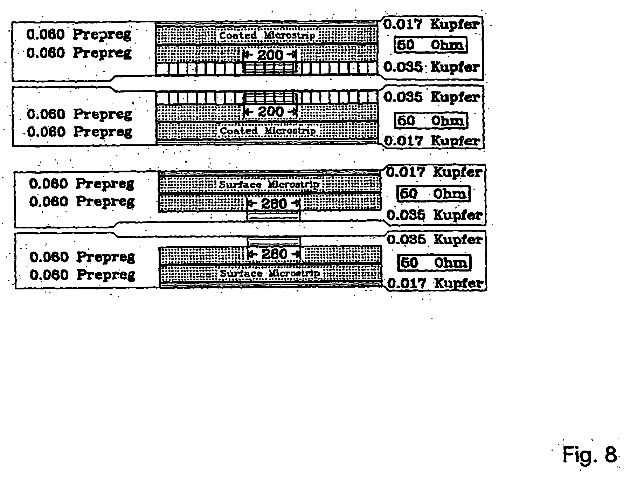

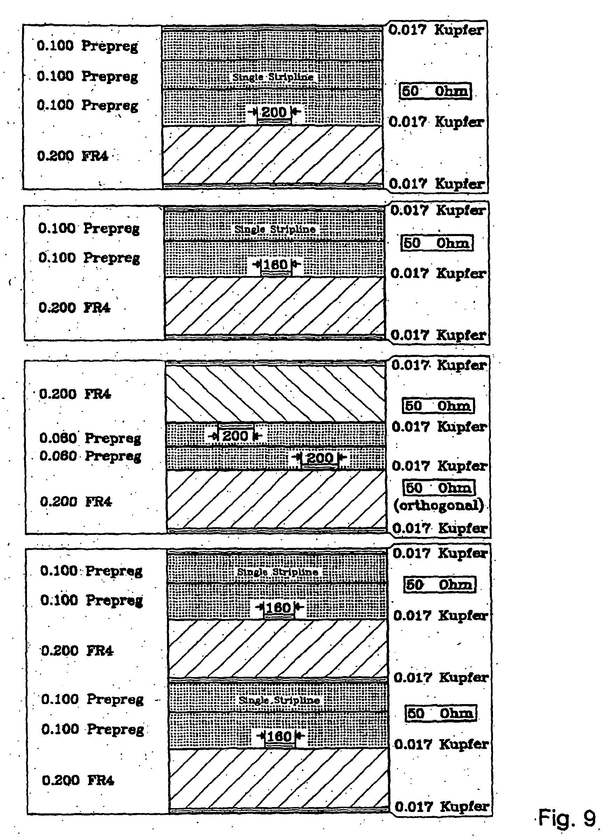

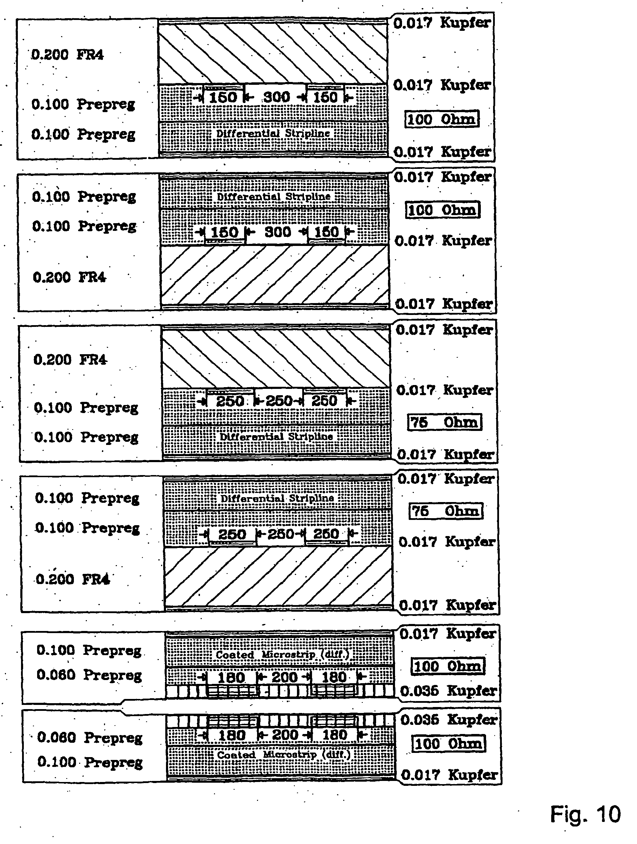

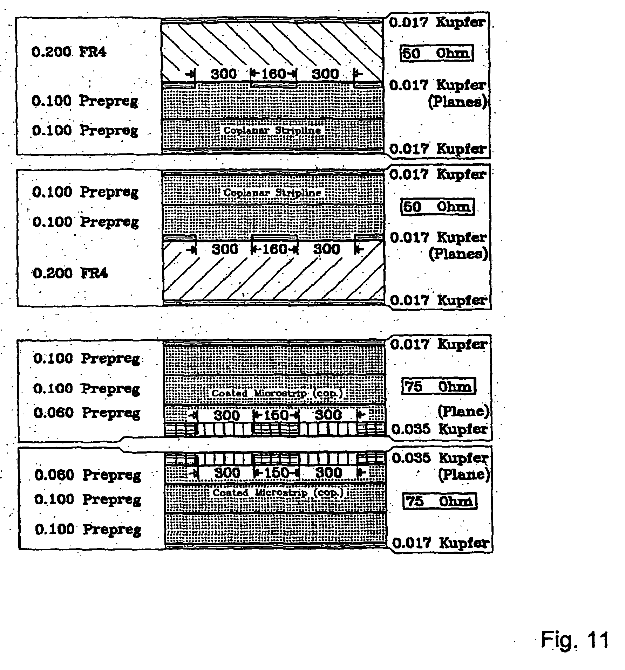

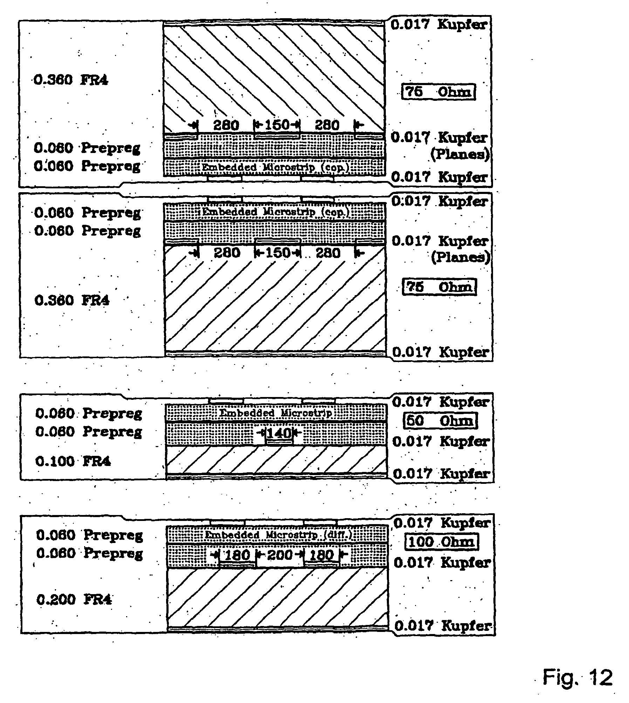

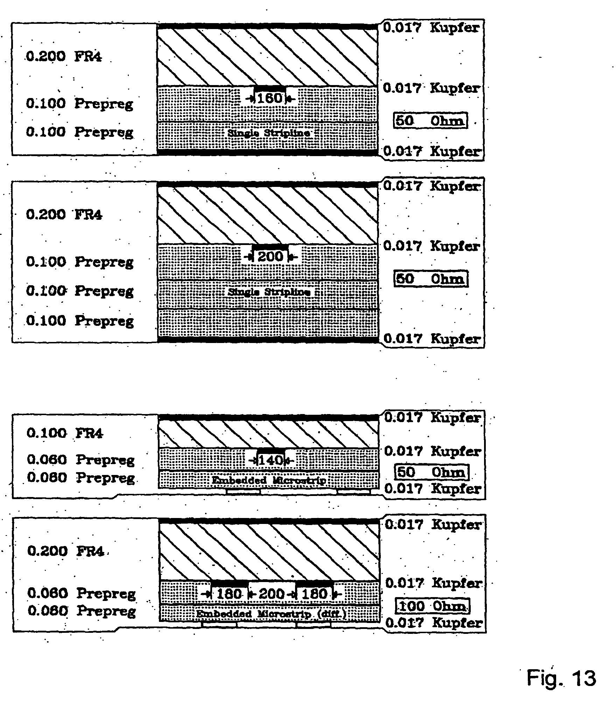

Die Figuren 8 bis 13 zeigen Darstellungen unterschiedlicher Kombinations-Module. Bei den Kombinations-Modulen handelt es sich um Module, die einen kombinierten Schichtenaufbau, der anwendungsmäßig realisierbar ist, zeigen. Aufgrund des Know-Hows des Leiterplattenherstellers wurden Ergebnisse für die elektrischen Eigenschaften dieser Kombinations-Module ermittelt, die bereits in den Feldern der Kombinations-Module eingetragen sind. Diese ermöglichen es dem Schaltungsentwickler, die elektrischen Eigenschaften ohne eigene Berechnungen allein aufgrund der Auswahl der geeigneten Schichten-Module zu erlangen.

Mit Hilfe der Schichtenmodule ist es somit möglich, den Schichtenaufbau einer mehrschichtigen Leiterplatte zur Realisierung einer elektronischen Schaltung zu simulieren und vorab auf Machbarkeit zu überprüfen. Die dargestellten Module stellen hierbei nur einen Teil der Auswahlmöglichkeiten.dar. Sie sind zwar in der konkreten Ausgestaltung auf die aktuellen Fertigungsmöglichkeiten eines bestimmten Leiterplattenherstellers abgestimmt, die Ausgestaltung lässt sich aber ohne das erfindungsgemäße Prinzip zu verlassen an andere Fertigungsmöglichkeiten anpassen oder aktualisieren. Diese Anpassungen betreffen im wesentlichen Dickenabstufungen, die Kombinationsmöglichkeiten bei Kombinations-Modulen und die elektrischen Angaben bei Kombinations-Modulen.

Alle Module weisen Angaben der Leiterbahnbreite, des Ohm-Wertes, der Leiterbahndicke und der Laminat- sowie Isolierschichtabstände auf.

## Patentansprüche

1. Schichtenmodell für den Entwurf einer mehrschichtigen Leiterplatte, bestehend aus einem Montagerahmen und einer Vielzahl Schichtenmodule, die zur Simulation des Schichtenaufbaus der mehrschichtigen Leiterplatte bündig aneinsetzbar und in den Montagerahmen einsetzbar sind.

2. Schichtenmodell nach Anspruch 1, **dadurch gekennzeichnet, dass** die Schichtenmodule wenigstens Basismaterial-Module der Leiterplatte, Isolierschichten-Module und Leiterbahh-Module umfassen.

3. Schichtenmodell nach Anspruch-2, **dadurch gekennzeichnet, dass** die Schichtenmodule zusätzlich Kombinations-Module aus' miteinander kombinierten Basismaterial-Modulen und/oder Isolierschichten-Modulen und/oder Leiterbahn-Modulen und/oder Impedanz-Modulen und/oder Entkopplungs-Modulen und/oder Kapazitäts-Modulen und/oder Versteifungs-Modulen und/oder Kühlungs-Modulen umfassen.

4. Schichtenmodell nach einem der Ansprüche 1 bis 2, **dadurch gekennzeichnet, dass** zusätzlich Kontaktierungs-Module und/oder Bohrungs-Module zum Auflegen oder Anlegen an die Schichtenmodule vorgesehen sind.

5. Schichtenmodell nach einem der Ansprüche 1 bis 4, **dadurch gekennzeichnet, dass** der Montagerahmen und wenigstens ein Teil der Schichtenmodule Codierungsnasen und/oder Codierungsausnehmungen aufweist, die beim bündigen Aneinandersetzen ineinander greifen.

6. Schichtenmodell nach einem der Ansprüche 1 bis 5, **dadurch gekennzeichnet, dass** die Schichtenmodule sowie die Kontaktierungs-Module und Bohrungs-Module bezogen auf die Schichtdicke der mehrschichtigen Leiterplatte maßstabsgetreu in einem vergrößerten Maßstab ausgeführt sind.

7. Schichtenmodell nach einem der Ansprüche 1 bis 6, **dadurch gekennzeichnet, dass** die Schichtenmodule sowie die Kontaktierungs-Module und Bohrungs-Module mehrfach und in den praxisüblichen Dicken- und Längenabstufungen vorhanden sind.

8. Schichtenmodell nach einem der Ansprüche 1 bis 7, **dadurch gekennzeichnet, dass** die Schichtenmodule sowie die Kontaktierungs-Module und Bohrungs-Module Symbole und Beschriftungen tragen.

9. Schichtenmodell nach einem der Ansprüche 1 bis 8, **dadurch gekennzeichnet, dass** der Montagerahmen Beschriftungen trägt.

10. Schichtenmodell nach Anspruch 8 oder 9, **dadurch gekennzeichnet, dass** als Material ein nicht-transparenter Werkstoff dient und die Beschriftungen doppelseitig angeordnet sind.

11. Schichtenmodell nach Anspruch 8 oder 9, **dadurch gekennzeichnet, dass** als Material ein transparenter Werkstoff dient und die Beschriftungen einseitig angeordnet sind.

12. Schichtenmodell nach Anspruch 10 oder 11, **dadurch gekennzeichnet, dass** zusätzlich Informationskarten aus dem gleichen Werkstoff mit Hinweisen für den Anwender vorgesehen sind.

## Claims

1. Layer model for designing a multilayer printed circuit board, consisting of a mounting frame and a plurality of layer modules which can be placed flush against one another and inserted into the mounting frame in order to simulate the layer structure of the multilayer printed circuit board.

2. Layer model according to claim 1, **characterised in that** the layer modules include at least base material modules of the printed circuit board, insulating layer modules and trace modules.

3. Layer model according to claim 2, **characterised in that** the layer modules additionally include combination modules consisting of combined base material modules and/or insulating layer modules and/or trace modules and/or impedance modules and/or decoupling modules and/or capacitance modules and/or stiffening modules and/or cooling modules.

4. Layer model according to one of claims 1 to 2, **characterised in that** additionally contacting modules and/or hole modules are provided for placing on or applying to the layer modules.

5. Layer model according to one of claims 1 to 4, **characterised in that** the mounting frame and at least some of the layer modules have coding protrusions and/or coding recesses which engage in one another when placed flush against one another.

6. Layer model according to one of claims 1 to 5, **characterised in that** the layer modules and the contacting modules and hole modules are designed to scale but larger than the layer thickness of the multilayer printed circuit board.

7. Layer model according to one of claims 1 to 6, **characterised in that** the layer modules and the contacting modules and hole modules are present in multiples and in the thickness and length increments customary in practice.

8. Layer model according to one of claims 1 to 7, **characterised in that** the layer modules and the contacting modules and hole modules bear symbols and inscriptions.

9. Layer model according to one of claims 1 to 8, **characterised in that** the mounting frame bears inscriptions.

10. Layer model according to claim 8 or 9, **characterised in that** the material used is a non-transparent material and the inscriptions are arranged on both sides.

11. Layer model according to claim 8 or 9, **characterised in that** the material used is a transparent material and the inscriptions are arranged on one side.

12. Layer model according to claim 10 or 11, **characterised in that** additionally information cards made from the same material are provided with instructions for the user.

## Revendications

1. Architecture en couches pour l'implantation d'un circuit imprimé multicouches, comprenant un châssis de montage et un grand nombre de modules en couches susceptibles d'être placés les uns contre les autres pour simuler la structure en couches du circuit imprimé multicouches et insérables dans le châssis de montage.

2. Architecture en couches selon la revendication 1, **caractérisée en ce que** les modules en couches incluent au minimum des modules en matériau de base du circuit imprimé, des modules de couches isolantes et des modules de pistes.

3. Architecture en couches selon la revendication 2, **caractérisée en ce que** les modules en couches incluent par ailleurs des modules combinés composés de modules en matériau de base combinés entre eux et/ou de modules de couches isolantes et/ou de modules de pistes et/ou de modules d'impédance et/ou de modules de découplage et/ou de modules de capacité et/ou de modules de renforcement et/ou de modules de refroidissement.

4. Architecture en couches selon l'une des revendications 1 à 2, **caractérisée en ce qu'**il est prévu de plus des modules de connexion intérieure et/ou des modules à trous à placer ou à appliquer sur les modules en couches.

5. Architecture en couches selon l'une des revendications 1 à 4, **caractérisée en ce que** le châssis de montage et au moins une partie des modules en couches présentent des ergots de codage et/ou des évidements de codage s'emboîtant les uns dans les autres quand ils sont placés côte à côte.

6. Architecture en couches selon l'une des revendications 1 à 5, **caractérisée en ce que** les modules en couches ainsi que les modules de connexion intérieure et les modules à trous sont exécutés, concernant l'épaisseur de la couche du circuit imprimé multicouches, à une échelle plus grande en respectant les proportions.

7. Architecture en couches selon l'une des revendications 1 à 6, **caractérisée en ce que** les modules en couches ainsi que les modules de connexion intérieure et les modules à trous existent en plusieurs exemplaires et dans les gradations habituelles en matière d'épaisseur et de longueur.

8. Architecture en couches selon l'une des revendications 1 à 7, **caractérisée en ce que** les modules en couches ainsi que les modules de connexion intérieure et les modules à trous portent des symboles et des étiquetages.

9. Architecture en couches selon l'une des revendications 1 à 8, **caractérisée en ce que** le châssis de montage porte des étiquetages.

10. Architecture en couches selon la revendication 8 ou 9, **caractérisée en ce que** le matériau est constitué d'une matière première non transparente et **en ce que** les étiquetages sont disposés recto-verso.

11. Architecture en couches selon la revendication 8 ou 9, **caractérisée en ce que** le matériau est constitué d'une matière première transparente et **en ce que** les étiquetages sont disposés d'un seul côté.

12. Architecture en couches selon la revendication 10 ou 11, **caractérisée en ce que** sont prévues par ailleurs des cartes d'informations de la même matière première comportant des indications destinées à l'utilisateur.
